# EUROPEAN PATENT APPLICATION

(11) **EP 1 282 208 A1**
(43) Date of publication of application: **05.02.2003**
(21) Application number: 01306520.6
(22) Date of filing: 30.07.2001
(51) Int. Cl.: H01S 5/227

(54) **Semiconductor laser structure and method of manufacturing same**

(71) Applicant: Agilent Technologies, Inc. (a Delaware corporation), Palo Alto, CA 94303 (US)
(72) Inventor: Fang, Ruyiyu, 10045 Torino (IT); Paoletti, Roberto, 10060 Airasca (TO) (IT)
(74) Representative: Coker, David Graeme

(57) **Abstract**

A semiconductor laser structure including a substrate (1) and an active region comprising at least one active laser layer (3). The substrate (1) has a front surface (1a) and the active region (3) is included in a ridge formation (12) protruding from the front surface (1a) of the substrate (1). The ridge formation (12) extends in the direction of the laser cavity and includes at least two opposed lateral extensions (13) defining respective bonding pads distributed along the length of the laser cavity.

## Description

The present invention refers to semiconductor lasers and, more specifically, to semiconductor laser structures of the kind called for in the preamble of claim 1.

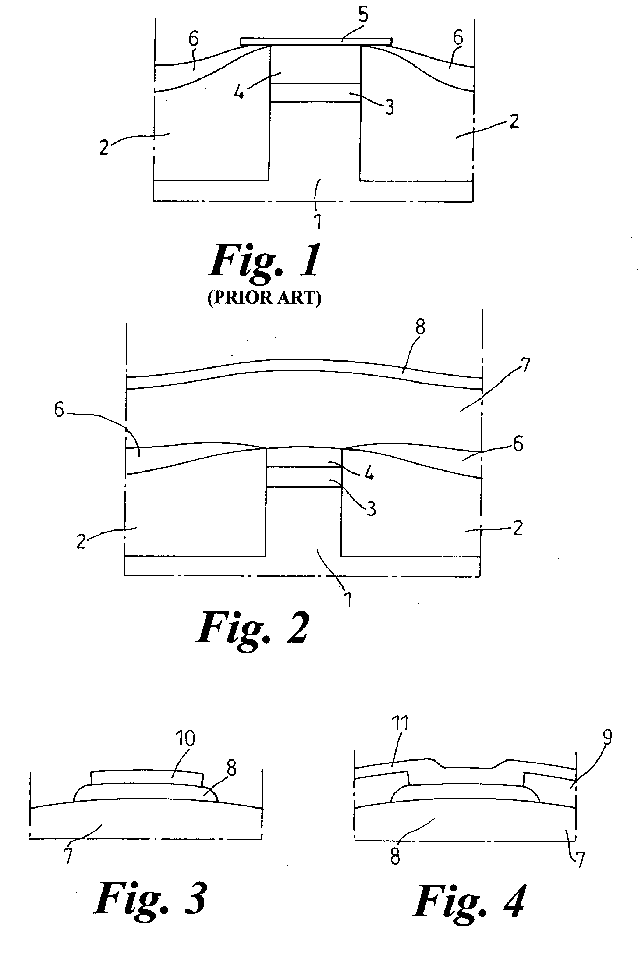

Exemplary of such structures is the arrangement shown in figure 1, which is currently referred to as a SIBH (Semi-Insulating Buried Heterojunction) structure.

Specifically, figure 1 shows the mesa definition of a SI-BH laser, where reference numeral 1 denotes a n-type substrate defining a mesa like structure laterally confined by an Fe-InP semi-insulating layer 2. Reference numeral 3 denotes the MQW active (i.e. lasing) layers over which a further p layer 4 and a SiO₂ mask 5 are provided. Finally, reference numeral 6 indicates an n-InP layer superposed onto the Fe-InP semi-insulating layers and adjoining the sides of mask 5 as an anti-diffusion layer to prevent Zn-Fe interdiffusion.

The structure described in the foregoing is conventional in the art and may be resorted to for manufacturing, i.a. SIBH-DFB (Distributed Feed Back) lasers operating e.g. in the 1.3 micrometer wavelength range.

High speed systems such as 10Gbit/s Ethernet systems require uncooled laser sources capable of high temperature operation (above 80-90°C) as well as fast direct modulation behaviour. To achieve this, laser structures with low leakage currents together with low parasitics are strongly required.

Recently, devices with operating ranges extending above 100° C have been demonstrated by using multi-junction blocking layers.

The main disadvantage of these structures is related to their intrinsic high parasitic capacitance (hundreds of picofarads).

To reduce parasitic capacitance, fairly complicated structures including dielectric layers together with reduced contact area and narrow trenches (few microns away from the active stripe) are practically mandatory. Nevertheless, the minimum capacitance which may be achieved by resorting to these structures is in the range of 3 to 5 pF, which is still too high for the usual driver requirements.

Semi-insulating blocking layers (usually InP:Fe) are another possible solution, leading to a notable reduction of parasitics (capacitance values smaller than 1 pF have been demonstrated) and leakage currents at room temperature. A typical disadvantage of these prior art structures are leakage currents at high temperatures, due to the significant reduction in resistivity of the material with temperature; this may be about two orders of magnitude between 20 and 100°C.

Also, from US-A-5 825 047 an optical semiconductor device is known comprising a stripe-mesa structure provided on a semi-insulating substrate. The stripe-mesa structure comprises an undoped light absorption layer sandwiched by cladding layers and by burying layers on both sides. This structure aims at reducing device capacitance to provide wide bandwidth and ultrahigh operation properties.

The need therefore exists for laser structures which are not unduly complicated and still offer the possibility of reducing both the leakage current and the parasitic capacitance, together with a good flexibility from the electrical point of view (e.g. number of bonding pads, directional bonding, uniform high speed injection over the active stripe).

The object of the present invention is to satisfy such a need.

According to the present invention, such an object is achieved by means of a laser structure having the features set forth in the annexed claims. The invention also concerns the related manufacturing process.

According to the invention, leakage current is reduced by etching the laser structure to form a ridge closely surrounding (about 10 micrometers away) the active stripe, thus reducing currents flowing in the lateral confinement layer. These currents are caused by recombination of carriers in the Fe-doped layer and by defects intrinsic to the technological process.

The reduced lateral area of the device thus obtained also leads to a reduction of parasitic capacitance, typically from 6 to less than 2 pF (as required by a typical IC driver), while providing bonding pads large enough for accommodating two 50 micrometers tape or wire bonding arrangements.

In the presently preferred embodiment of the invention, two bonding pads are used which are longitudinally distributed or staggered along the ridge formation i.e. the active region or cavity of the laser device. Consequently, this is suitable for very high speed applications (in the 40 Gbit/s range), where modulation transit time plays a significant role.

Also, in the presently preferred embodiment of the invention, two possibilities are offered for wire bonding directions, this resulting in maximum flexibility in module design. This aspect is significant for high speed applications, where the IC driver and the laser should be designed jointly to minimise parasitic inductance and capacitance in order to permit real microwave design of the module.

The invention will now be described, by way of example only, with reference to the annexed drawings, where:
- figure **1,** related to the prior art, has been already described in the foregoing,
- figures **2** to **6** schematically show subsequent steps in the manufacturing process of a semiconductor laser structure according to the invention, and
- figure **7** is a perspective view of a low parasitic capacitance laser structure according to the invention.

In figures 2 to 6 parts and components of a SIBH-DFB semiconductor laser structure which are identical or functionally equivalent to those already described in connection with figure 1 are designated by the same reference numerals appearing in figure 1.

Specifically, figures 2 to 4 show some standard regrowth steps which are typical of processes for manufacturing SI-BH structures according to the general prior art arrangement shown in figure 1.

Specifically, figure 2 shows that a p layer 7 and an InGaAs layer 8 have been grown over layers 4 and 6.

A contact window in the InGaAs layer is defined as shown in figure 3 using a photoresist 10 as a mask. After removing the mask, a SiO₂ layer is deposited by PECVD (Plasma Enhance Chemical Vapour Deposition), a contact window is opened and a Ti-Au metallization 11 is evaporated with a thickness compatible with a following etching step (see figure 4).

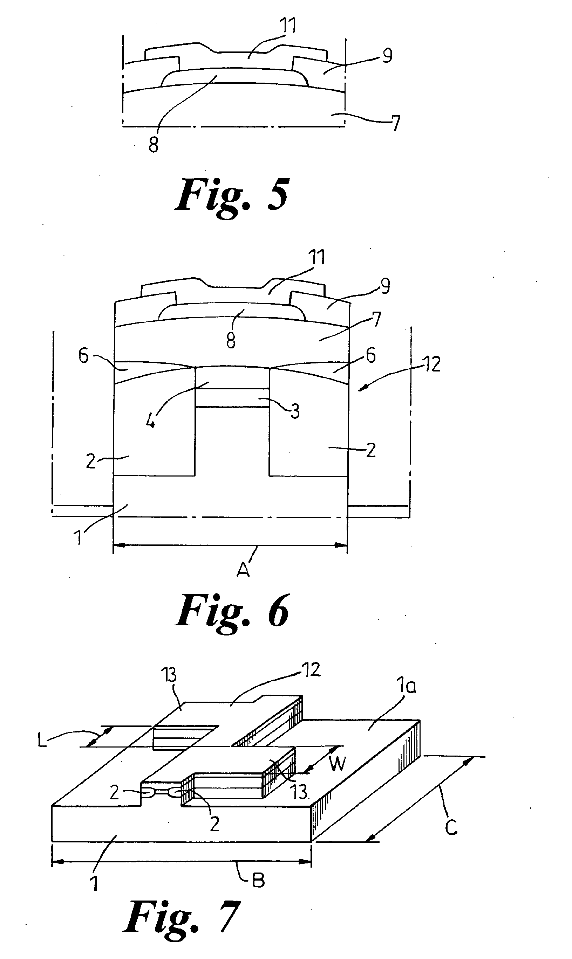

The p metal pattern is defined by conventional photolithography using a positive photoresist. The metals can be finally defined as shown in figure 5 by selective wet chemical etching, using the photoresist mentioned above as a mask.

Finally, as shown in figure 6, a ridge is etched down to the substrate 1 by using e.g. standard Reactive Ion Etching or wet chemical etching. After the photoresist is removed, final passivation and contact window opening steps are then performed in a conventional manner.

The final result thus obtained essentially leads to the active MQW Layers of the laser structure to be included in a ridge formation 12 protruding from a front (upper) surface 1a of substrate 1.

The structure thus obtained can be essentially paralleled to the standard mesa structure of SI-BH laser having been included in an outer mesa structure, thus leading to a sort of a general "mesa-in-the-mesa" structure.

Typical values of the "width" (designated A in figure 6) of ridge formation 12 are in the range of 10 to 15 micrometers while the homologous dimension (designated B in figure 7) of the laser chip i.e. the substrate 1, are in the range of 200 micrometers. The overall length of the laser chip (designated C in figure 7) substantially correspond to the length of the laser cavity and is thus in the range of 300 micrometers.

In the arrangement shown, all the parasitic and current leakage phenomena related to the lateral confinement layers of the basic mesa structure of the laser device are drastically reduced as these layers are practically dispensed with.

Preferably, ridge structure 12 is shaped in plan view in order to have at least one and still preferably two bonding areas or pads 13 extending sidewise of ridge structure 12. These are preferably arranged according to a general "double-L", "S-shaped" or "asymmetrical-butterfly" shape, thus providing opposed bonding areas 13 distributed or staggered along the laser structure.

The presence of two bonding areas 13 distributed along the active laser stripe is beneficial in reducing modulation transit time. The structure of the present invention is thus particularly suitable for very high speed applications (e.g. in the 40 Gbit/s range).

The asymmetric pad configuration shown in figure 7 with a bonding pad 13 located at each side of the laser active stripe is advantageous in that it allows two wire bonding towards the IC driver from both left and/or back sides of the laser.

The preferred embodiment shown in the drawings provides an excellent compromise in terms of the number of pads the need of keeping parasitic capacitance as low as possible depending on the IC characteristics.

The distance (designated L in figure 7) between the pads 13 in the direction of the laser cavity can be set to a very minimum value (virtually to zero) in order to reduce the overall length C of the laser.

The dimension L can however be optimised according to the laser cavity length. To optimize the microwave paths, the dimension L is preferably selected as L = C/2 - W, where W denotes the lateral dimension (i.e. the length) of the pad (see figure 7). For a laser cavity in the 300 micrometer range and a square pad with sides of about 80 micrometers, a preferred value of the distance L is about 70 micrometers which allows a uniform distribution of the microwave field.

Of course, the basic principles of the invention remaining the same, the details and embodiments may vary with respect to the exemplary embodiment shown herein without departing from the scope of the invention as defined in the annexed claims.

## Claims

1. A semiconductor laser structure including a substrate (1) and an active region comprising at least one active laser layer (3), **characterised in that** said substrate (1) has a front surface (1a) and said active region (3) is included in a ridge formation (12) protruding from said front surface (1a) of said substrate (1).

2. The semiconductor laser of claim 1, **characterised in that** said ridge formation (12) includes at least one lateral extension (13) defining a bonding pad.

3. The semiconductor laser of claim 2, **characterised in that** said active region (3) extends in a given direction and said ridge formation (12) includes at least two said lateral extensions (13) defining respective bonding pads distributed along the length of said active region.

4. The semiconductor laser of claim 3, **characterised in that** said at least two lateral extensions (13) are arranged at a given distance (L) along the length of said active region.

5. The semiconductor laser of claim 4, **characterised in that** said distance (L) is related to the length of said active region.

6. The semiconductor laser of claim 5, **characterised in that** said distance (L) is substantially equal to C/2 - W, where C is said length of said active region and W is the lateral dimension of said extensions (13).

7. The semiconductor laser of any of claims 3 to 6, **characterised in that** said at least two lateral extensions (13) are arranged at opposite sides of said active region.

8. A process for manufacturing a semiconductor laser structure according to any of claims 1 to 7, **characterised in that** it comprises the steps of:
- providing a substrate (1) for said laser structure
- growing over said substrate (1) a plurality of layers defining an active region comprising at least one active laser layer (3), and
- selectively removing at least part of the layers grown on said substrate 1) to produce a front surface (1a) of said substrate (1) as well as a ridge formation (12) including said active region, whereby said active region (3) is included in said ridge formation (12) protruding from said front surface (1a) of said substrate (1).
